# EUROPÄISCHE PATENTSCHRIFT

(11) **EP 2 100 354 B1**
(45) Veröffentlichungstag und Bekanntmachung des Hinweises auf die Patenterteilung: **07.01.2015**
(21) Anmeldenummer: 07846872.5
(22) Anmeldetag: 29.11.2007
(51) Int. Cl.: H02B 1/38

(54) **SCHALTSCHRANKANORDNUNG**
CONTROL BOX ARRANGEMENT
DISPOSITIF D'ARMOIRE DE COMMANDE

(30) Priorität: 12.12.2006 DE 102006058780
(43) Veröffentlichungstag der Anmeldung: 16.09.2009
(73) Patentinhaber: RITTAL GmbH & Co. KG, 35745 Herborn (DE)
(72) Erfinder: SCHELL, Michael, 35687 Dillenburg (DE); BECKER, Tobias, 35398 Lützellinden (DE); SCHAAF, Igor, Harry, 77836 Rheinmünster (DE)
(74) Vertreter: Tönhardt, Marion
(86) Internationale Anmeldenummer: PCT/EP2007/010346
(87) Internationale Veröffentlichungsnummer: WO 2008/071308

(56) Entgegenhaltungen:
- EP-A- 0 154 287
- CH-A5- 607 598
- DE-A1- 19 837 379

## Beschreibung

Die Erfindung bezieht sich auf eine Schaltschrankanordnung mit mindestens einem Schaltschrank, dessen Innenraum in mehrere übereinander angeordnete Teilräume unterteilt oder unterteilbar ist, die mittels zugeordneter Teiltüren mittels einer im Bereich von deren Innenseite zur Wirkung kommenden umlaufenden Dichtungsanordnung dichtend verschließbar ist, wobei die Teiltüren auf ihrer einen vertikalen Seite mittels Scharnieren an einem Rahmengestell des betreffenden Schaltschrankes angelenkt und auf ihrer gegenüberliegenden vertikalen Seite mittels eines Verschlussmechanismus verschließbar ist und wobei ein erster Scharnierabschnitt mittels eines Befestigungsabschnittes an einem vertikalen Abschnitt des Rahmengestelles befestigt ist und die Teiltür an einem Gelenkabschnitt des ersten Scharnierabschnittes mittels eines an ihr angebrachten zweiten Scharnierabschnitts gelenkig gelagert ist. Eine derartige Schaltschrankanordnung ist in der DE 41 11 402 C2 angegeben. Bei dieser bekannten Schaltschrankanordnung mit einem Schaltschrank sind übereinander angeordnete Teilräume mit frontseitigen Teiltüren verschlossen, die auf einer vertikalen Seite mit Scharnieren an einem frontseitigen vertikalen Rahmenschenkel eines Rahmengestells angelenkt und auf ihrer anderen Seite mit Verschlusselementen an einem gegenüberliegenden frontseitigen vertikalen Rahmenschenkel verschließbar sind. Auf der Innenseite der mit seitlichen Abkantungen versehenen Teiltür ist eine umlaufende Dichtung aufgespritzt, die mit umlaufenden rahmenartigen Stegelementen dichtend zusammenwirken, die die Teilräume frontseitig umgrenzen. Die rahmengestellseitigen Scharnierabschnitte sind in einem auf der Außenseite gebildeten Freiraum des betreffenden vertikalen Rahmenschenkels angebracht, während der betreffende vertikale Abschnitt der umlaufenden Dichtung mit einem auf der Frontseite bezüglich der betreffenden Schrankseite nach innen versetzten Stegabschnitt des vertikalen Rahmenschenkels zusammenwirkt. Für die Montage des Scharnierabschnittes müssen auf der Außenseite des Rahmenschenkels betreffende Montageelemente vorgesehen werden.

Die DE 40 13 379 C1 zeigt einen Schaltschrank mit Rahmengestell und Schrankfächern, die mittels Teiltüren verschliessbar sind, wobei nähere Ausführungen zum Aufbau der Schrankfächer und horizontalen Dichtungsstege für die Teiltüren gemacht sind.

In der DE 10 2004 054 173 A1 ist eine Schaltschrankanordnung gezeigt, bei der mittels vertikaler Trennwände mehrere Teilräume im Schrankinneren gebildet sind. Ferner sind im Schrankinnem Verteilschienen und Hauptschienen eines Stromversorgungssystems angebracht, womit ein Schrank für eine Niederspannungsanlage bereitgestellt wird.

Eine Schaltschrankanordnung mit den Merkmalen des Oberbegriffs von Anspruch 1 ist aus der DE 198 37 379 A1 bekannt, die ein Gehäuse mit abgekantetem Rahmen zeigt, wobei jedoch nicht von Teiltüren die Rede ist. Hier liegt der Befestigungsabschnitt des ersten Scharnierteils außerhalb des zu dem abgekanteten Rahmen gehörenden umlaufenden, stegartigen Dichtrandes, lediglich die Schraubbefestigungen ragen ins Innere des Gehäuses und sind dort mittels Muttern festgespannt.

Die EP 0 154 287 A und CH 607 598 A5 zeigen jeweils einen Schaltschrank bzw. ein Gehäuse mit Rahmen und daran im geschlossenen Zustand gedichtet angebrachter Tür, die an dem Rahmen mittels erster und zweiter Scharnierteile angelenkt ist. Dabei ist bei der EP 0 154 287 A vorgesehen, das erste Scharnierteil mit seinem Befestigungsabschnitt im geschlossenen Zustand innerhalb des Dichtungsbereiches anzuordnen, wobei die Dichtung allerdings nicht an der Tür sondern an dem Rahmen angebracht ist. Bei der CH 607 598 A5 liegt das erste Scharnierteil, abgesehen von einem ins Innere des Gehäuses durch den Gehäuserand ragenden Schraubbolzen, außerhalb der umlaufenden Türdichtung. Auch wird die Problematik von Schaltschränken mit Teiltüren nicht angesprochen.

Der Erfindung liegt die Aufgabe zugrunde, eine Schaltschrankanordnung zu schaffen, mit der eine möglichst variable Aufteilung des Schrankinnenraums in Teilräume bei günstiger Abdichtung erleichtert wird.

Diese Aufgabe wird mit den Merkmalen des Anspruches 1 gelöst. Insbesondere ist vorgesehen, dass der Befestigungsabschnitt im geschlossenen Zustand innerhalb der umlaufenden Dichtungsanordnung angeordnet ist, während der Gelenkabschnitt außerhalb der Dichtungsanordnung angeordnet ist.

Mit diesen Maßnahmen kann die Scharnierung auf einfache Weise im inneren Bereich des Schaltschrankes befestigt werden, wobei die Tür im geöffneten Zustand aus dem Öffnungsbereich der Teilräume, insbesondere Funktionsräume mit eingebauten Gerätekomponenten herausgeschwenkt werden kann, insbesondere um mehr als 90°. Auf der Außenseite des Rahmengestells brauchen keine besonderen Befestigungselemente angebracht zu werden. Eine günstige Befestigung der Scharniere an dem Rahmengestell ergibt sich dadurch, dass der Befestigungsabschnitt auf einer in Tiefenrichtung des vertikalen Abschnittes gerichteten Befestigungsebene befestigt ist und über einen nach außen abgewinkelten Halteabschnitt, der quer über die Frontseite des vertikalen Abschnittes verläuft, in den Gelenkabschnitt übergeht. Da vorgesehen ist, dass der Halteabschnitt im Anschluss an seinen Verlauf über die Frontseite des vertikalen Abschnittes zunächst nach hinten, um einen Hohlraum zu bilden, und anschließend wiederum nach außen abgebogen ist und dort in den Gelenkabschnitt übergeht, wird eine einfache, eindeutige Montage mit günstiger Anordnung der Lagerachse z. B. in einem außen gebildeten Freiraum eines Vertikalprofils erhalten. Der Hohlraum ergibt eine eindeutige Anordnung, wobei mittels einer im inneren Bereich des Befestigungsabschnittes angeordneten Haltenase eine einfache Vorfixierung erreicht wird, wonach dann der Scharnierabschnitt auf einfache Weise mit Schrauben befestigt werden kann. Zu einer zuverlässigen Abdichtung tragen überdies die Maßnahmen bei, dass im Übergangsbereich des Hohlraumes zu dem Gelenkabschnitt eine sich axial bezüglich des Scharniers erstreckende Scharnierdichtung angebracht ist, die sich mit einer achsparallel von einem Dichtkörper erstreckenden Dichtlippe an den frontseitigen Abschnitt des vertikalen Abschnittes anschmiegt.

Eine günstige Abdichtung wird weiter dadurch erreicht, dass die Dichtungsanordnung eine auf der Innenseite der Teiltür aufgebrachte umlaufende Dichtung aufweist, die mit einer umlaufenden rahmenartigen Steganordnung auf der Frontseite des betreffenden Schaltschranks zusammenwirkt, wobei abgekantete Randbereiche außerhalb der umlaufenden Dichtung und außerhalb des zweiten Scharnierabschnittes liegen.

Ebenfalls günstig ist, wenn die umlaufende Dichtung im geschlossenen Zustand über den Halteabschnitt verläuft.

Da vorgesehen ist, dass der Halteabschnitt im Anschluss an seinen Verlauf über die Frontseite des vertikalen Abschnittes zunächst nach hinten, um einen Hohlraum zu bilden, und anschließend wiederum nach außen abgebogen ist und dort in den Gelenkabschnitt übergeht, wird eine einfache, eindeutige Montage mit günstiger Anordnung der Lagerachse z. B. in einem außen gebildeten Freiraum eines Vertikalprofils erhalten. Der Hohlraum ergibt eine eindeutige Anordnung, wobei mittels einer im inneren Bereich des Befestigungsabschnittes angeordneten Haltenase eine einfache Vorfixierung erreicht wird, wonach dann der Scharnierabschnitt auf einfache Weise mit Schrauben befestigt werden kann. Zu einer zuverlässigen Abdichtung tragen überdies die Maßnahmen bei, dass im Übergangsbereich des Hohlraumes zu dem Gelenkabschnitt eine sich axial bezüglich des Scharniers erstreckende Scharnierdichtung angebracht ist, die sich mit einer achsparallel von einem Dichtkörper erstreckenden Dichtlippe an den frontseitigen Abschnitt des vertikalen Abschnittes anschmiegt.

Mit den Maßnahmen, dass der vertikale Abschnitt Teil eines vertikalen Rahmenschenkels des Rahmengestells ist, der mit mindestens einer in einem Rasterabstand mit Löchern versehenen Befestigungslochreihe versehen ist, wird eine einfache, variable Anordnungsmöglichkeit der Teiltüren entsprechend einer variablen Anordnungsmöglichkeit von Teilräumen ermöglicht, ohne auf der Außenseite des Rahmengestells zusätzliche Befestigungen, beispielsweise Löcher, anbringen zu müssen.

Eine vorteilhafte Ausgestaltung besteht darin, dass die umlaufende Dichtung auf der Innenseite der Teiltür und/oder die Scharnierdichtung aufgespritzt ist/sind.

Die Abdichtung wird des Weiteren dadurch begünstigt, dass die umlaufende Dichtung im Bereich der ersten Scharnierabschnitte im Bereich des vertikalen Verlaufs eine Ausbuchtung nach außen aufweist über den zurückversetzten Bereich des Halteabschnittes.

Ferner tragen zu einer zuverlässigen Abdichtung die Massnahmen bei, dass die ersten Scharnierabschnitte im Bereich ihrer Halteabschnitte gegenüber den zugekehrten horizontalen Abschnitten der rahmenartigen Steganordnung in vertikaler Richtung mit Aussparungen versehen sind, so dass die Abdichtung entlang der rahmenartigen Steganordnung ungestört ist.

Die Zahl der Einzelteile und einfache Montage werden ferner dadurch begünstigt, dass eine Teiltür mit zwei Scharnierteilen versehen sind, von denen das eine oben und das andere unten angeordnet ist, wobei die jeweiligen Bolzen in entgegengesetzter Richtung aus dem zugeordneten Gelenkabschnitt ragen.

Die Erfindung wird nachfolgend anhand von Ausführungsbeispielen unter Bezugnähme auf die Zeichnungen näher erläutert. Es zeigen:
Fig. 1 eine Schaltschrankanordnung mit abgenommenen Türen und teilweise abgenommenen Wandelementen mit mehreren Funktionsräumen in perspektivischer Ansicht,
Fig. 2A und 2B eine Schaltschrankanordnung mit einem Schaltschrank mit mehreren durch vertikale Trennwände gebildeten Teilräumen in Draufsicht und mit mehreren horizontal abgetrennten Teilräumen in Frontansicht mit Teiltüren,
Fig. 3 eine gläserne Darstellung eines Schaltschrankes mit horizontal getrennten Teilräumen, einem Verteilschienensystem und daran angeschlossenen Gerätekomponenten in perspektivischer Ansicht, Fig. 4 die Ausführung nach Fig. 3 in Frontansicht,
Fig. 5 die Ausführung nach Fig. 3 in Draufsicht,
Fig. 6 einen Ausschnitt eines Schaltschrankes mit mehreren horizontal voneinander getrennten Funktionsräumen in perspektivischer Vorderansicht mit Verteilschienensystem,
Fig. 7 einen Ausschnitt eines Schaltschrankes in einem Eckbereich eines Teilraumes in Form eines Funktionsraumes in perspektivischer Ansicht,
Fig. 8 einen Seitenwandbereich eines Schaltschrankes von innen mit seitlichen Wandabschnitten,
Fig. 9 einen Seitenwandbereich eines Schaltschrankes mit einem gelösten Seitenwandabschnitt in perspektivischer Ansicht,
Fig. 10 zwei unterschiedlich hohe Seitenwandabschnitte in perspektivischer Ansicht und einen vergrößerten Ausschnitt eines Seitenwandabschnittes in dessen Eckbereich,
Fig. 11 eine Teil-Montageplatte in perspektivischer Ansicht,
Fig. 12 eine Teiltür in perspektivischer Ansicht,
Fig. 13 einen Montagewinkel in perspektivischer Ansicht,
Fig. 14 einen Raumteilerboden in perspektivischer Ansicht, Fig. 15 einen Abschnitt eines Trennstegs in perspektivischer Ansicht,
Fig. 16A einen Ausschnitt eines Schaltschranks im Übergangsbereich zweier Teilräume mit einem oberen und einem unteren Scharnierabschnitt für eine obere und eine untere Teiltür in perspektivischer Ansicht,
Fig. 16B ein abgenommenes Scharnierteil nach Fig. 16A in perspektivischer Ansicht von der Außenseite,
Fig. 16C den Scharnierteil nach Fig. 16B von der Innenseite,
Fig. 17 einen Querschnitt eines vertikalen Rahmenschenkels mit angebrachtem Scharnierteil,
Fig. 18 Abschnittes eines vertikalen Rahmenschenkels mit einem oberen und einem unteren Scharnierteil in auseinander gezogener Darstellung,
Fig. 19A einen Ausschnitt eines Schaltschrankes mit einem Teilraum und daran angelenkter, geöffneter Teiltür in perspektivischer Darstellung und
Fig. 19B einen Ausschnitt in einem Eckbereich nach Fig. 19A mit eingezeichneter virtueller Lage eines Dichtungsverlaufs im geschlossenen Zustand der Tür.

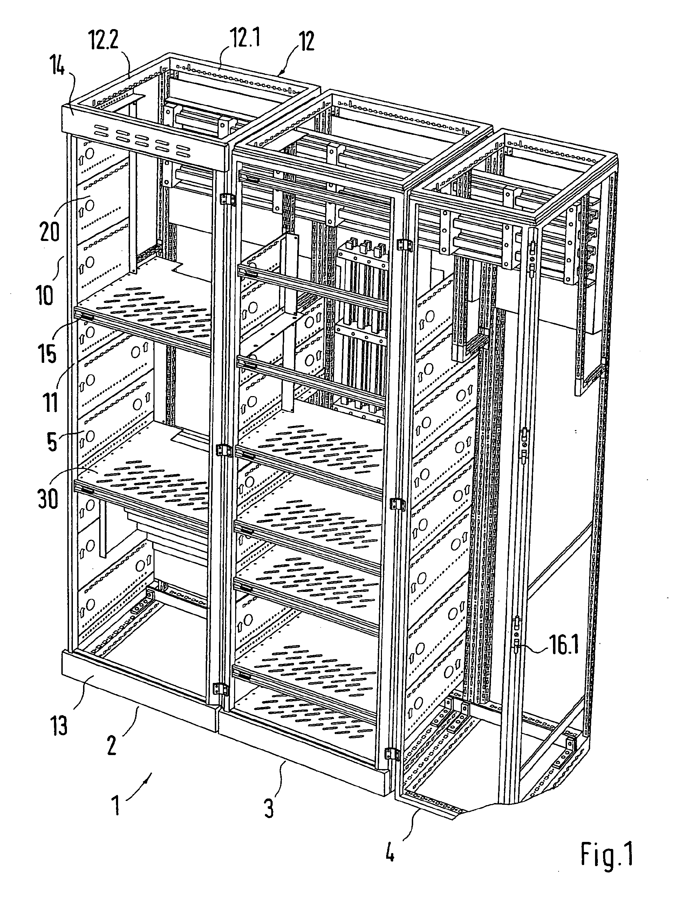

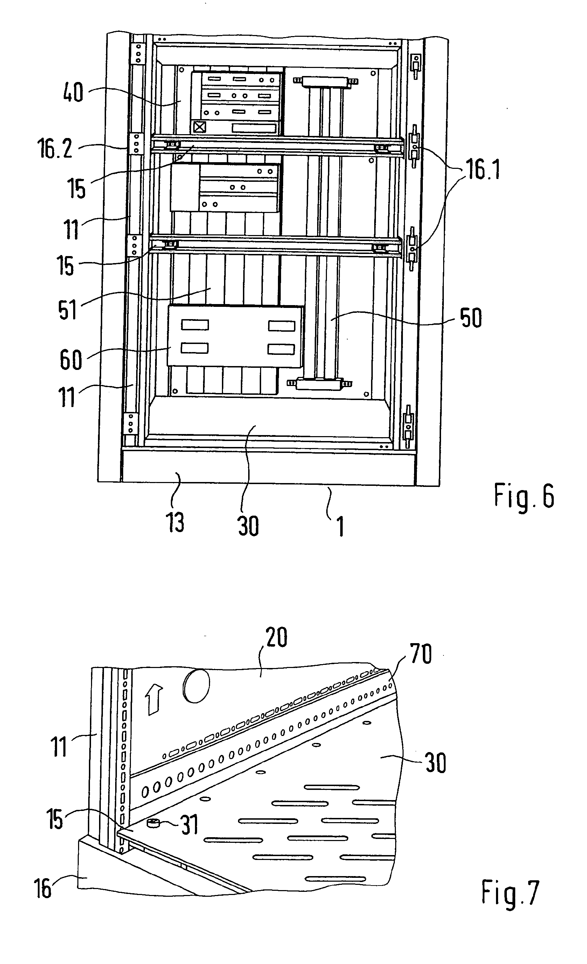

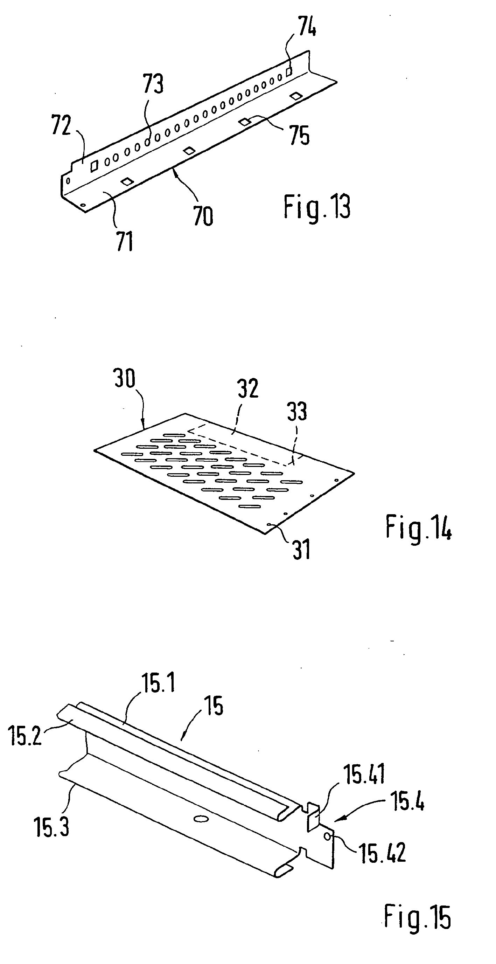

Fig. 1 zeigt eine Schaltschrankanordnung 1 mit mehreren mit ihren jeweiligen Rahmengestellen seitlich aneinander gereihten Schaltschränken 2, 3, 4, wobei der rechte Schaltschrank eine gegenüber den beiden anderen Schaltschränken 2, 3 geringere Breite besitzt und lediglich einen von unten bis oben durchgehenden Innen-räum aufweist, während die beiden anderen Schaltschränke 2, 3 mehrere horizontal übereinander liegende Teilräume 5 in Form von Funktionsräumen unterschiedlicher Höhe aufweisen. Im rückwärtigen Bereich der Schaltschrankanordnung 1 ist ein Hauptschienensystem mit mehreren horizontal verlaufenden Stromschienen angeordnet, während in dem mittleren Schaltschrank 3 vertikale Verteilschienen angeordnet sind, die an die Hauptschienen mittels elektrisch leitender, in den Stromführungseigenschaften angepasster Verbindungselemente angeschlossen sind. Die Verteilschienen verlaufen senkrecht durch mehrere Funktionsräume und sind auf der Vorderseite von Rückwandabschnitten in Form von den Funktionsräumen zugeordneten Montageplatten 40 mittels entsprechender Sammelschienenhalter montiert und vom Innenraum der Funktionsräume aus zugänglich. Auf den Verteilschienen sind entsprechende Geräteadapter für den Anschluss von Gerätekomponenten kontaktierend aufgesetzt. Zwischenräume zwischen den Geräteadaptem sind mittels isolierender Abdeckungen berührungssicher zum Innenraum der Funktionsräume hin verschlössen. Die Verteilschienen verlaufen durch mehrere übereinander angeordnete Funktionsräume, wobei im hinteren Bereich von horizontalen Raumteilerböden 30 (vgl. auch Fig. 6 und 14) entsprechende Ausschnitte 32 vorgesehen sind, die an die Ausdehnung der Verteilschienen mit Abdeckungen angepasst sind.

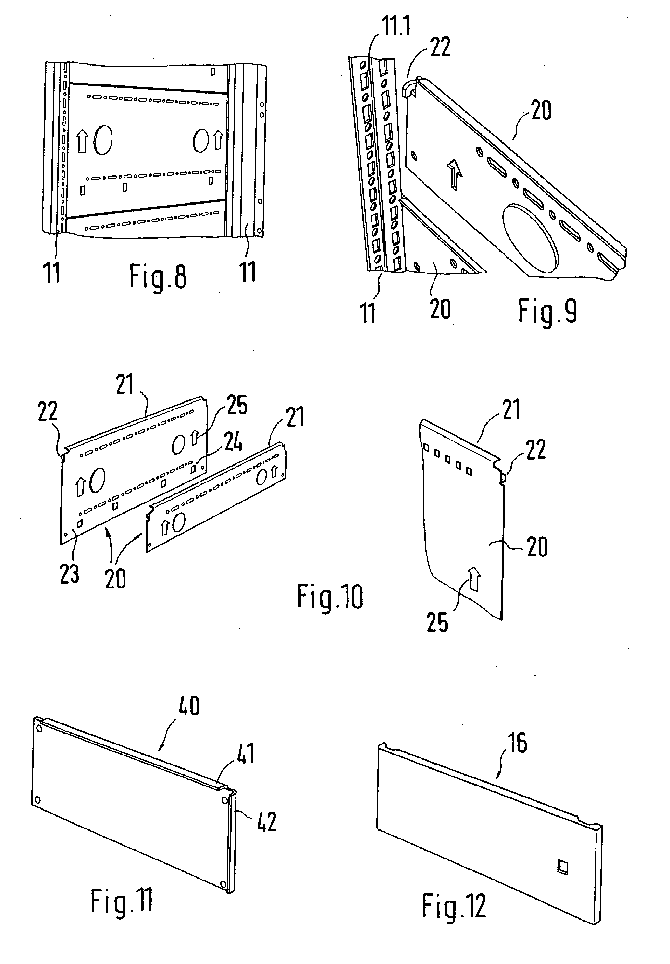

Ferner zeigt Fig. 1, dass die Schaltschränke 2, 3, 4 Rahmengestelle 10 mit vier in den Eckbereichen angeordneten vertikalen Rahmenschenkeln 11 und Deckrahmen mit in Breitenrichtung und Tiefenrichtung verlaufenden Rahmenschenkeln 12.1 bzw. 12.2 aufweisen. Ferner sind die Schaltschränke 2, 3, 4 mit jeweiligen Sockeln 13 versehen. Im Bereich des vorderen Randes der Raumteilerböden 30 sind im Querschnitt U-förmige Trennstege 15 angeordnet, deren Öffnungsseiten nach vom gerichtet sind, wobei die freien Enden der Seitenschenkel 15.1 , 15.3 bündig sind mit den vorderen Rändern der vertikalen Rahmenschenkel 11 bzw. der Frontebene des Rahmengestells 10. Auf der Vorderseite des Deckrahmens 12 ist eine obere Frontblende 14 angebracht. Zum Verschließen der Frontseite der Schaltschränke ist ent-weder eine von oben bis unten durchgehende Fronttür oder es sind den jeweiligen Funktionsräumen zugeordnete und in der Höhe angepasste Teiltüren 16 (vgl. Fig. 12) vorgesehen, die an jeweiligen, an den vertikalen Rahmenschenkeln 11 angebrachten Scharnierteilen 16.1 mit komplementären Scharnierteilen gelenkig gelagert und an jeweils zugeordneten, an den gegenüberliegenden vertikalen Rahmenschenkeln 1 1 angeordneten Verschlussteilen 16.2 getrennt verschließbar sind.

Die horizontal übereinander liegenden Teilräume 5 in Form der Funktionsräume sind seitlich mit an die Höhe der Funktionsräume angepassten Seitenwandabschnitten 20 begrenzt, die mit ihrem vorderen vertikalen Randbereich an den dortigen vertikalen Rahmenschenkeln 11 und an ihrem hinteren vertikalen Randbereich entweder an den hinteren vertikalen Rahmenschenkeln 11 oder an vertikalen Montageschenkeln angebracht sind, die in der Ebene der Rückwandabschnitte der Funktionsräume angeordnet sind. Zusätzlich zu den die Funktionsräume seitlich begrenzenden Seitenwandabschnitten 20 sind die betreffenden Schaltschränke 2 bzw. 4 mit durchgehenden äußeren Seitenwänden abgeschlossen, ebenso wie auch die Rückseite der Schrankanordnung 1 sowie deren Oberseite.

Die Seitenwände 20 sind an ihrem oberen Randbereich zunächst unter stumpfem Winkel schräg nach innen und oben bezüglich des Funktionsraums und dann wiederum nach aussen und oben parallel zu dem oberen Rand abgewinkelt, wie auch die Fig. 9 und 10 erkennen lassen. Im oberen Eckbereich ist ein nach aussen von der Ebene des Seitenwandabschnittes 20 vorstehendes abgebogenes Hakenelement 22 angeordnet, das an die Länge von vertikal gerichteten Langlöchern in dem betreffenden vertikalen Rahmenschenkel 11 bzw. Montageschenkel angepasst und in diesen mit einer nach unten zeigenden Haltenase einhängbar ist. Dabei ist vorzugsweise vorgesehen, dass die vertikalen Rahmenschenkel 11 eine den vorderen Rahmenbereich des Rahmengestells 10 umgrenzende innere seitliche Montageebene und eine davon von der Frontseite abgekehrt liegende zur Seite nach außen abgesetzte, ebenfalls zur Innenseite der Rahmenschenkel 11 gekehrte äußere seitliche Montageebene aufweisen, wobei sowohl die innere als auch die äußere Montageebene der vertikalen Rahmenschenkel 11 Befestigungslochreihen aufweisen. Die Seitenwandabschnitte 20 sind mit den Hakenelementen vorzugsweise in der äußeren, seitlich zurückversetzten Montageebene eingehängt, wobei auch der vertikale Montageschenkel eine entsprechende Befestigungslochreihe in der entsprechenden Ebene aufweist. Zusätzlich zu den Hakenelementen 22 sind im unteren vorderen und hinteren Eckbereich der Seitenwandabschnitte 20 Befestigungslöcher angeordnet, die sich mit Befestigungsöffnungen in den vertikalen Rahmenschenkeln 11 bzw. den betreffenden vertikalen Montageschenkeln decken und zum Sichern eine Schraubverbindung ermöglichen. Zudem weisen die Seitenwandabschnitte 20 an ihrem unteren Randbereich 23 und gegebenenfalls auch in ihrem oberen Randbereich 21 bzw. oberen Abschnitt eine horizontal verlaufende Lochanordnung 24 auf. Zur richtigen Orientierung mit dem in der genannten Weise abgebogenen oberen Rand nach oben sind die Seitenwandabschnitte 20 jeweils mit Ausrichtmarken 25 in Form eines nach oben gerichteten Pfeils versehen. Ferner weisen sie eine mittels einer abnehmbaren Platte abgedeckte oder an einer Perforierung ausbrechbare Öffnung für eine seitliche Zugänglichkeit z. B. in einen daneben angeordneten Kabelraum auf. Die Seitenwandabschnitte 20 sind in ihrer Höhe an die Höhe eines Funktionsraumes vorzugsweise in einem bestimmten Rastermaß, insbesondere entsprechend ganzzahligen Vielfachen von Höheneinheiten HE angepasst. Dabei können Seitenwandabschnitte 20 unterschiedlicher Höhe vorgesehen sein, um unterschiedlich hohe Funktionsräume zu bilden.

Entsprechend sind auch die Höhen der Teil-Montageplatten 40 und der Teiltüren 16 in einem bestimmten Rasterabstand, insbesondere entsprechend ganzzahligen Vielfachen von Höheneinheiten an die Höhe von Funktionsräumen angepasst, so dass sich eine Art Baukastensystem zum Aufbau gewünschter Funktionsräume ergibt, die entsprechend den Lochreihen und deren Raster in den vertikalen Rahmenschenkeln 11 sowie den vertikalen Montageschenkeln auch in unterschiedlichen Höhen des Schaltschrankinnenraums anzuordnen sind.

Zum Anordnen der Raumteilerböden 30 sind seitlich an den Seitenwandabschnitten 20 und/oder den vertikalen Rahmenschenkeln 11 bzw. den vertikalen Montageschienen anbringbare Montagewinkel 70 vorgesehen, die mit einem vertikalen Schenkel 72 entlang dem betreffenden Seitenwandabschnitt 20 verlaufen und mit ihrem horizontalen Schenkel 71 zum Inneren des Schrankraumes vorstehen, wobei zwei sich gegenüberliegende horizontale Schenkel 71 einen Raumteilerboden 30 auf ihrer Oberseite aufnehmen, der mittels in Öffnungen einer Lochreihe 73 bzw. einer Lochanordnung 31 (vgl. Fig. 13 und 14) eingreifender Elemente, insbesondere Schrauben verbindbar ist. Die horizontalen Schenkel 71 stehen dabei über die innere Montageebene der vertikalen Rahmenschenkel 11 in den Innenraum vor und die Ausdehnung des Raumteilerbodens 30 in Breitenrichtung ist vorteilhafterweise höchstens so breit bemessen, wie der Abstand zweier sich gegenüberliegender innerer Montageebenen, so dass der Raumteilerboden 30 ohne Schwierigkeiten in den Schaltschrankinnenraum eingeführt und an den Montagewinkeln 70 festgelegt werden kann, wobei auch der Ausschnitt 32 relativ zu den Verteilschienen passend positioniert ist.

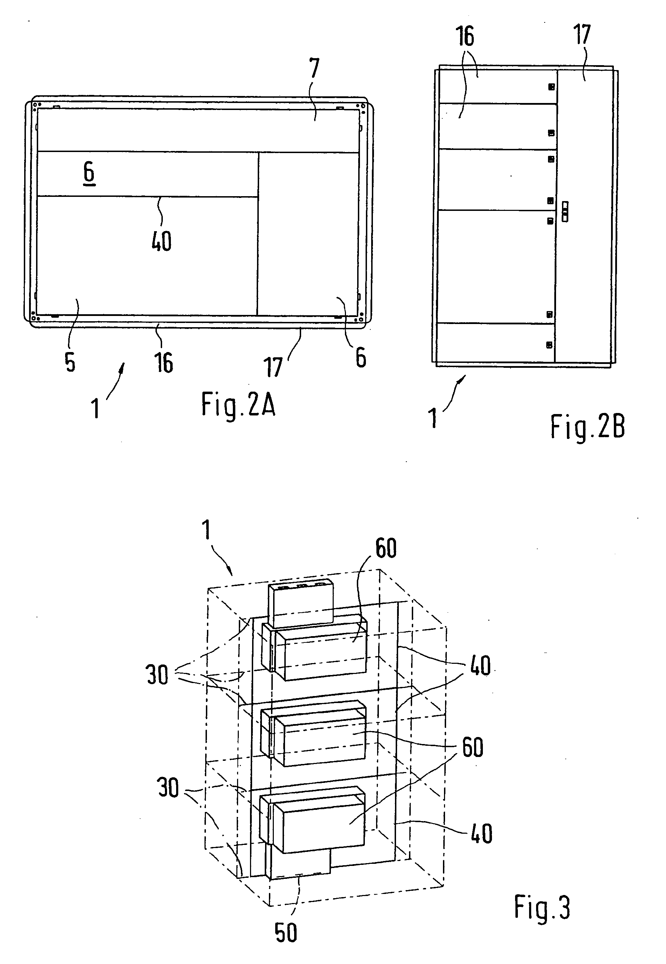

Die Fig. 2A und 2B zeigen Raumeinteilungsmöglichkeiten des Innenraums eines Schaltschranks zum einen in horizontaler Richtung durch Vertikaltrennwände und zum anderen in vertikaler Richtung durch die horizontalen Raumteilerböden 30.

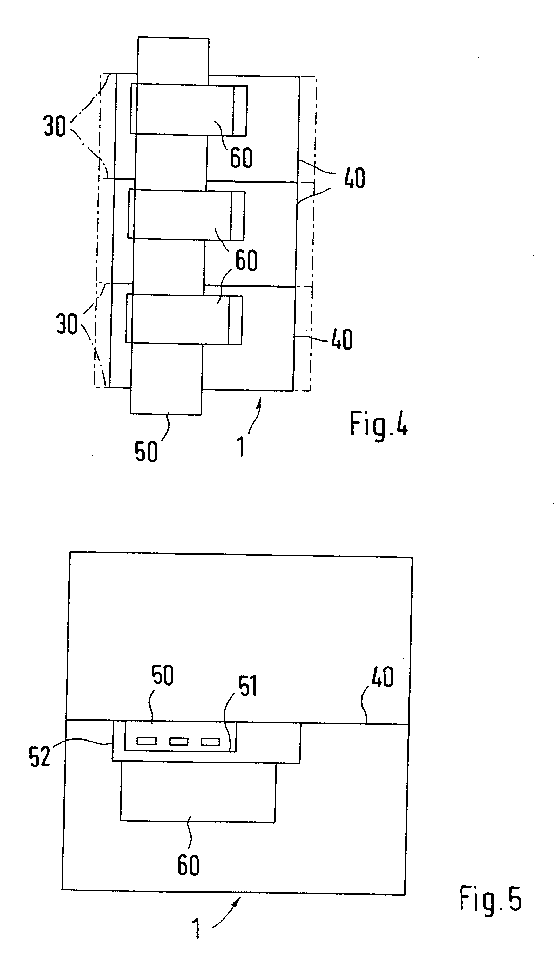

Die Fig. 3, 4, 5 lassen die Verteilschienenanordnung 50 mit Sammelschienenabdeckung 51 und auf die Verteilschienenanordnung 50 aufgesetzten Geräteadaptern 52 sowie daran angeschlossenen Schaltgeräten 60 erkennen. Auch Fig. 6 lässt die durch mehrere Funktionsräume verlaufende Anordnung der Verteilschienen 50 und ihre Durchführung durch die Ausschnitte 32 im hinteren Bereich der Raumteilerböden 30 erkennen. Wie Fig. 14 zeigt, kann der Ausschnitt 32 mittels einer Perforierung 33 im hinteren Randbereich des Raumteilerbodens 30 zum einfachen Ausbrechen vorbereitet sein, wobei der Ausschnitt 32 zum hinteren Rand des Raumteilerbodens 30 offen ist, so dass auch dadurch der Raumteilerboden 30 ohne weiteres nachträglich in beliebiger Höhe des Schaltschrankinnenraumes angeordnet und auch wieder herausgenommen werden kann, ohne die Verteilschienenanordnung 50 entfernen zu müssen.

Wie die Fig. 13 erkennen lässt, kann der Montagewinkel 70 mittels Befestigungslöcher 74, 75 und gegebenenfalls zur Seite auf der vom Innenraum abgekehrten Rückseite ausgebogener hakenförmiger Laschen an dem betreffenden Seitenwandabschnitt in deren Lochanordnung 24 eingehängt bzw. mit diesem verbunden werden.

Wie Fig. 15 zeigt, besitzen die U-förmigen Trennstege 15 in Verlängerung ihres Grundsteges 15.2 seitliche Befestigungsabschnitte 15.4 (auf beiden Seiten), die im eingebauten Zustand Absätze an den vertikalen Rahmenschenkeln 11 auf deren Rückseite hintergreifen und mittels durch Befestigungsöffnungen eingeführter Schrauben von der Rückseite befestigt werden. Außerdem können im Eckbereich der Befestigungsabschnitte 15.4 Freibereiche und zurückgebogene Halteelemente 15.41 gebildet sein.

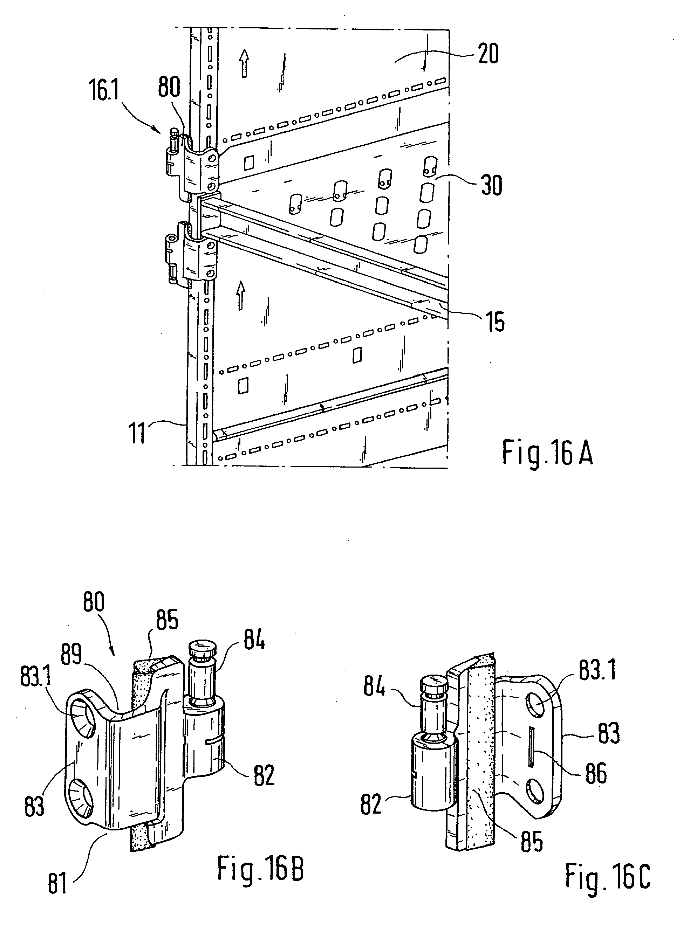

Fig. 16A zeigt einen in Fig. 1 dargestellten, an einem vertikalen Rahmenschenkel 11 angebrachten ersten Scharnierabschnitt 16.1 , der ein Scharnierteil 80 eines Scharniers für eine Teiltür 16 bildet, in näherer Darstellung. Die Fig. 16B, 16C sowie die Fig. 17, 18, 19A und 19B zeigen nähere Einzelheiten des Scharniers und der Teiltür 16.

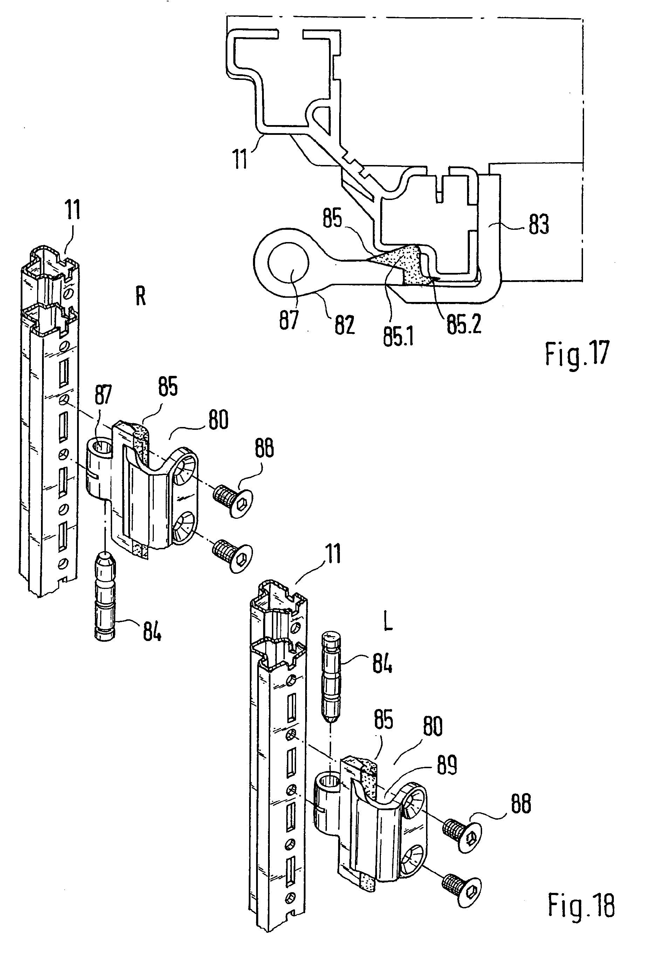

Der an einem vertikalen Abschnitt des Rahmengestells 10, vorliegend also an einem frontseitigen vertikalen Rahmenschenkel 11 angebrachte Scharnierteil 80 ist zum Bilden eines unteren Scharniers einer Teiltür 16 oberhalb des betreffenden Raumteilerbodens 30, und zwar oberhalb des Trennstegs 15, angeordnet, während ein weiteres Scharnierteil 80 zum Bilden eines oberen Scharniers einer darunter angeordneten Teiltür unterhalb des Raumteilerbodens 30 bzw. des Trennstegs 15 angeordnet ist, wobei beide Scharnierteile gleich ausgebildet, aber sich in der Orientierung ihrer Scharnierbolzen 84 unterscheiden. Der jeweilige Scharnierteil 80 ist auf der Innenseite der frontseitigen Schaltschranköffnung mittels eines Befestigungsabschnittes 83 an den Öffnungen einer dort an dem vertikalen Rahmenschenkel 11 angeordneten Befestigungslochreihe 11.1 befestigt, wobei die Befestigungslochreihe 11.1 in einem festen Rasterabstand voneinander beabstandete Befestigungslöcher aufweist. Der in den Fig. 16B, 16C und auch den Fig. 17 und 18 näher dargestellte Befestigungsabschnitt 83 weist entsprechend dem Rasterabstand ebenfalls Befestigungslöcher 83.1 auf, durch die Befestigungsschrauben 88 eingedreht werden können. Diese Anordnung an der Befestigungslochreihe 11.1 bietet die Möglichkeit, die Scharnierteile 80 beliebig im Rasterabstand anzuordnen, d.h. auch die Teiltüren 16 sowie die Teilräume beliebig zu positionieren.

Der Befestigungsabschnitt 83 geht über einen nach außen über die Frontseite des vertikalen Rahmenschenkels 11 verlaufenden, abgewinkelten Halteabschnitt 81 und einen entsprechend im weiteren Verlauf des Rahmenschenkelquerschnitts nach hinten abgebogenen Abschnitt eines Halteabschnittes 81 in einen nach aussen ragenden Gelenkabschnitt 82 über, an dem ein weiteres, an der Innenseite der Teiltür 16 angebrachtes Scharnierteil mittels eines Scharnierbolzens 84 gelenkig gelagert ist. Der Bolzen 84 weist umlaufende Rillen auf, mit denen er in einer Bolzenaufnahme 87 des Gelenkabschnittes 82 mittels eines darin angeordneten einschnappenden Federelementes gehalten ist. Bei dem unteren Scharnierteil 80 einer Teiltür 16 ist der Bolzen nach oben gerichtet, während er bei dem oberen Scharnierteil 80 nach unten gerichtet ist. Der Halteabschnitt 81 bildet durch die beschriebenen Abbiegungen einen den Frontabschnitt des vertikalen Rahmenprofils 11 umfassenden Hohlraum. Wie Fig. 16C zeigt, ist zwischen den Befestigungslöchern 83.1 des Befestigungsabschnittes 83 eine Haltenase 86 angeordnet, mit der der Scharnierteil 80 vermittels des Hohlraums an dem vertikalen Rahmenschenkel 11 vorfixierbar ist, so dass er anschließend leicht mittels der Schrauben befestigt werden kann. In dem Hohlraum auf dessen zu der Seite des Schaltschrankes liegendem Bereich ist eine Scharnierdichtung 85 aufgebracht, beispielsweise aufgeschäumt, mit der eine Abdichtung der Teiltür 16 ergänzt wird. Auch unterstützt die Scharnierdichtung 85 die Fixierfunktion. Die Scharnierdichtung 85 liegt mit einem Dichtungskörper 85.1 im seitlichen und vorderen Bereich des vertikalen Rahmenschenkels 11 an und ragt mit einer Dichtungslippe 85.2 über den vorderen Bereich des vertikalen Rahmenschenkels 11. In axialer Richtung des Scharniers erstreckt sie sich über dessen Länge.

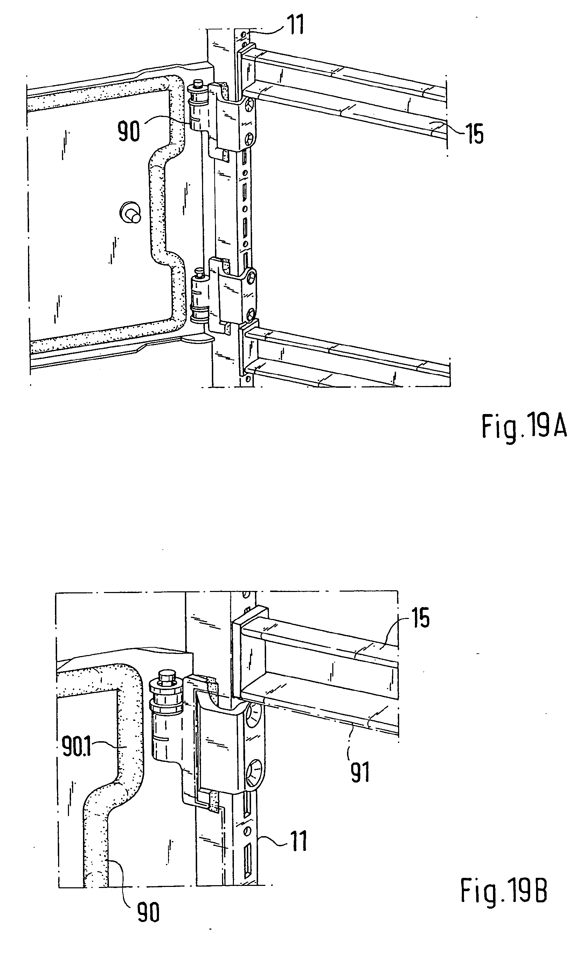

Der Halteabschnitt 81 ist in seinem zum oberen bzw. unteren Rand der Teiltür gerichteten Bereich mit einer Aussparung 89 versehen, so dass ein eindeutiger Übergang zwischen den den umlaufenden Dichtungsrahmen bildenden Stegabschnitten des Trennstegs 15 und des vertikalen Rahmenschenkels 11 frei bleibt und ein Übergang in den gegenüber der Frontseite zurückversetzten seitlichen äußeren Abschnitt des Halteabschnittes 81 erhalten wird. Wie die Fig. 19A und 19B zeigen, ist der über die Dichtungsstege des Trennstegs 15 und des vertikalen Rahmenschenkels 11 verlaufende Abschnitt der umlaufenden Dichtung im Bereich des Scharnierteils 80 nach außen mit einer Ausbuchtung 90.1 versehen, in deren Verlauf die Türdichtung 90 über den zurückversetzten Teil des Halteabschnittes 81 verläuft und eine zusammenhängende Abdichtung über diesen Abschnitt bewirkt, wie der virtuelle Türdichtungsverlauf 91 im geschlossenen Zustand nach Fig. 19B zeigt.

Der beschriebene modulare Aufbau für die Teilräume im Inneren des Schaltschrankes lässt eine variable Gestaltung bei einfacher Montage zu, wobei auch hohe An-forderungen an die Funktionssicherheit erfüllt werden, wie sie bei Niederspannungsanlagen gefordert sind.

## Patentansprüche

1. Schaltschrankanordnung mit mindestens einem Schaltschrank (2, 3, 4), dessen Innenraum in mehrere übereinander angeordnete Teilräume (5) unterteilt oder unterteilbar ist, die mittels zugeordneter Teiltüren (16) mittels einer im Bereich von deren Innenseite zur Wirkung kommenden umlaufenden Dichtungsanordnung (90, 85) dichtend verschließbar ist, wobei die Teiltüren (16) auf ihrer einen vertikalen Seite mittels Scharnieren an einem Rahmengestell (10) des betreffenden Schaltschrankes (2, 3,4) angelenkt und auf ihrer gegenüberliegenden vertikalen Seite mittels eines Verschlussmechanismus verschließbar ist, wobei ein erster Scharnierabschnitt (16.1) mittels eines Befestigungsabschnittes (83) an einem vertikalen Abschnitt des Rahmengestelles (10) befestigt ist und die Teiltür (16) an einem Gelenkabschnitt (82) des ersten Scharnierabschnittes (16.1) mittels eines an ihr angebrachten zweiten Scharnierabschnitts gelenkig gelagert ist, wobei der Befestigungsabschnitt (83) auf einer in Tiefenrichtung des vertikalen Abschnittes gerichteten Befestigungsebene befestigt ist und über einen nach außen abgewinkelten Halteabschnitt (81), der quer über die Frontseite des vertikalen Abschnittes verläuft, in den Gelenkabschnitt (82) übergeht, der im geschlossenen Zustand außerhalb der Dichtungsanordnung (90, 85) angeordnet ist,
**dadurch gekennzeichnet,**
**dass** der Befestigungsabschnitt (83) im geschlossenen Zustand innerhalb der umlaufenden Dichtungsanordnung (90, 85) angeordnet ist, und
**dass** der Halteabschnitt (81) im Anschluss an seinen Verlauf über die Frontseite des vertikalen Abschnittes zunächst nach hinten, um einen Hohlraum zu bilden, und anschließend wiederum nach außen abgebogen ist und dort in den Gelenkabschnitt (82) übergeht, wobei im Übergangsbereich des Hohlraumes zu dem Gelenkabschnitt (82) eine sich axial bezüglich des Scharniers erstreckende Scharnierdichtung (85) angebracht ist, die sich mit einer achsparallel von einem Dichtkörper (85.1) erstreckenden Dichtlippe (85.2) an den frontseitigen Abschnitt des vertikalen Abschnitts anschmiegt.

2. Schaltungsanordnung nach Anspruch 1,
**dadurch gekennzeichnet,**
**dass** die Dichtungsanordnung eine auf der Innenseite der Teiltür (16) aufgebrachte umlaufende Dichtung (90) aufweist, die mit einer umlaufenden rahmenartigen Steganordnung auf der Frontseite des betreffenden Schaltschranks (2, 3, 4) zusammenwirkt, wobei abgekantete Randbereiche außerhalb der umlaufenden Dichtung (90) und außerhalb des zweiten Scharnierabschnittes liegen.

3. Schaltschrankanordnung nach Anspruch 1 oder 2,
**dadurch gekennzeichnet,**
**dass** die umlaufende Dichtung (90) im geschlossenen Zustand über den Halteabschnitt (81) verläuft.

4. Schaltschrankanordnung nach einem der Ansprüche 1 bis 3,
**dadurch gekennzeichnet,**
**dass** der vertikale Abschnitt Teil eines vertikalen Rahmenschenkels (11) des Rahmengestells (10) ist, der mit mindestens einer in einem Rasterabstand mit Löchern versehenen Befestigungslochreihe (11.1) versehen ist.

5. Schaltschrankanordnung nach einem der Ansprüche 2 bis 4,
**dadurch gekennzeichnet,**
**dass** die umlaufende Dichtung (90) auf der Innenseite der Teiltür (16) und/oder die Scharnierdichtung (85) aufgespritzt ist/sind.

6. Schaltschrankanordnung nach einem der Ansprüche 1 bis 5,
**dadurch gekennzeichnet,**
**dass** die umlaufende Dichtung (90) im Bereich der ersten Scharnierabschnitte (16.1) im Bereich des vertikalen Verlaufs (91) eine Ausbuchtung (90.1) nach außen aufweist über den zurückversetzten Bereich des Halteabschnittes (81).

7. Schaltschrankanordnung nach einem der Ansprüche 2 bis 6,
**dadurch gekennzeichnet,**
**dass** die ersten Scharnierabschnitte (16.1) im Bereich ihrer Halteabschnitte (81) gegenüber den zugekehrten horizontalen Abschnitten der rahmenartigen Steganordnung in vertikaler Richtung mit Aussparungen (89) versehen sind, so dass die Abdichtung entlang der rahmenartigen Steganordnung ungestört ist.

8. Schaltschrankanordnung nach einem der Ansprüche 1 bis 7,
**dadurch gekennzeichnet,**
**dass** eine Teiltür (16) mit zwei Scharnierteilen (80) versehen ist, von denen das eine oben und das andere unten angeordnet ist, wobei die jeweiligen Bolzen (84) der Scharnierteile in entgegengesetzter Richtung aus dem zugeordneten Gelenkabschnitt (82) ragen.

## Claims

1. A control box arrangement with at least one control box (2, 3, 4), whose interior is subdivided or is subdividable into a plurality of compartments (5) arranged one above the other and is closable by associated compartment doors (16) in a sealing manner by means of a peripheral sealing arrangement (90, 85) that performs its function in the region of the inside of these compartment doors (16), wherein the compartment doors are hinge-mounted to a frame (10) of the associated control box (2, 3, 4) by means of hinges on their one vertical side and are closable by means of a closing mechanism on their opposite vertical side, wherein a first hinge section (16.1) is fastened to a vertical section of the frame (10) by means of a fastening section (83) and the compartment door (16) is mounted in articulating fashion on an articulating section (82) of the first hinge section (16.1) by means of a second hinge section attached to it, wherein the fastening section (83) is fastened in a fastening plane oriented in the depth direction of the vertical section and, by means of an outwardly angled holding section (81), which extends transversely across the front surface of the vertical section transitions into the bearing section (82) situated outside the sealing arrangement (90, 85) in the closed state,
**characterized in that**,
in the closed state, the fastening section (83) is situated inside the peripheral sealing arrangement (90, 85), and
the holding section (81), after extending across the front surface of the vertical section, first extends toward the rear in order to form a cavity and then bends outward again, transitioning at that point into the bearing section (82), wherein a hinge seal (85) extending axially in relation to the hinge is mounted in the transition region from a cavity to the bearing section (82) and has a sealing lip (85.2) extending from a seal body (85.1) in an axially parallel fashion and fittings snugly against the front surface section of the vertical section.

2. The control box arrangement according to claim 1, **characterized in that** the sealing arrangement as a peripheral seal (90) mounted on the inside of the compartment door (16) that cooperates with a peripheral, frame-like arrangement of divider strips on the front of the associated control box (2, 3, 4) with folded edge regions being situated outside the peripheral seal (90) and outside the second hinge section.

3. The control box arrangement according to claim 1 or 2, **characterized in that** in the closed state, the peripheral seal (90) extends across the holding section (81).

4. The control box arrangement according to one of claims 1 to 3, **characterized in that** the vertical section is part of a vertical frame leg (11) of the frame (10) and is provided with at least one row or fastening holes (11.1), whose holes are arranged in a spacing pattern.

5. The control box arrangement according to one of claims 2 to 4, **characterized in that** the peripheral sealing (90) on the inside of the compartment door (16) and/or the hinge seal (85) is/are spray-mounted.

6. The control box arrangement according to one of claims 1 to 5, **characterized in that** in the region of the vertical segment (91), the peripheral sealing (90) has an outward bulge (90.1) in the vicinity of each of the first hinge sections (16.1), extending across the recessed region of the holding section (81).

7. The control box arrangement according to one of claims 2 to 6, **characterized in that** in the region of their holding sections (81), the first hinge sections (16.1) are provided with recesses (89) in relation to the horizontal sections of the frame-like arrangement of divider strips facing them so that there is no distortion of the seal along the frame-like arrangement of divider strips.

8. The control box arrangement according to one of claims 1 to 7, **characterized in that** a compartment door (16) is provided with two hinge parts (80), one situated at the top and the other situated at the bottom, wherein the respective bolts (84) of the hinge parts extend in opposite directions out of the respective articulating section (82).

## Revendications

1. Ensemble d'armoire de commande, comportant au moins une armoire de commande (2, 3, 4), dont l'intérieur est divisé ou est divisible en plusieurs compartiments (5) superposés, qui, au moyen de portes partielles (16) correspondantes, peuvent être fermés de manière étanche par un système d'étanchéité (90, 85) périphérique, agissant dans la zone du côté intérieur de ces portes partielles, lesdites portes partielles (16) étant articulées au moyen de charnières, sur l'un de leurs côtés verticaux, sur un bâti (10) de l'armoire de commande (2, 3, 4) concernée et pouvant être fermées au moyen d'un mécanisme de verrouillage sur leur côté vertical opposé, une première partie de charnière (16.1) étant fixée par une partie de fixation (83) sur une partie verticale du bâti (10), et la porte partielle (16) étant montée de manière articulée sur une partie d'articulation (82) de la première partie de charnière (16.1) au moyen d'une deuxième partie de charnière fixée sur ladite porte partielle, la partie de fixation (83) étant fixée sur un plan de fixation orienté dans le sens de la profondeur de la partie verticale et, par l'intermédiaire d'une partie de retenue (81) coudée vers l'extérieur et s'étendant transversalement sur le côté frontal de la partie verticale, se prolongeant dans la partie d'articulation (82) qui, dans la position fermée, est disposée en dehors du système d'étanchéité (90, 85),
**caractérisé**
**en ce que** la partie de fixation (83), dans la position fermée, est disposée à l'intérieur du système d'étanchéité (90, 85) périphérique, et
**en ce que** la partie de retenue (81), dans le prolongement de son tronçon sur le côté frontal de la partie verticale, est pliée d'abord vers l'arrière, pour former un espace creux, et ensuite à nouveau vers l'extérieur et, à cet emplacement, se prolonge dans la partie d'articulation (82) ; dans la zone de transition entre l'espace creux et la partie d'articulation (82) est disposé un joint d'étanchéité de charnière (85), qui s'étend axialement par rapport à la charnière et qui, avec une lèvre d'étanchéité (85.2) orientée parallèlement à l'axe d'un corps d'étanchéité (85.1), s'applique étroitement contre la partie du côté frontal de la partie verticale.

2. Ensemble d'armoire de commande selon la revendication 1, **caractérisé en ce que** le système d'étanchéité comporte un joint d'étanchéité (90) périphérique, qui est posé sur la face intérieure de la porte partielle (16) et qui coopère avec une nervure périphérique, en forme de cadre, sur la face frontale de l'armoire de commande (2, 3, 4) concernée, des zones de bordure repliées étant disposées en dehors du joint d'étanchéité (90) périphérique et en dehors de la deuxième partie de charnière.

3. Ensemble d'armoire de commande selon la revendication 1 ou 2, **caractérisé en ce que**, dans la position fermée, le joint d'étanchéité (90) périphérique s'étend sur la partie de retenue (81).

4. Ensemble d'armoire de commande selon l'une quelconque des revendications 1 à 3, **caractérisé en ce que** la partie verticale fait partie d'une branche (11) verticale du bâti (10), laquelle est munie d'au moins une série de trous de fixation (11.1), formée par des trous écartés les uns des autres selon une trame.

5. Ensemble d'armoire de commande selon l'une quelconque des revendications 2 à 4, **caractérisé en ce que** le joint d'étanchéité (90) périphérique sur la face intérieure de la porte partielle (16) et/ou le joint de charnière (85) est/sont moulé(s) par injection.

6. Ensemble d'armoire de commande selon l'une quelconque des revendications 1 à 5, **caractérisé en ce que** le joint d'étanchéité (90) périphérique, dans la zone des premières parties de charnière (16.1) dans la zone du tronçon vertical (91), comporte un bombement (90.1) vers l'extérieur au-dessus de la zone en retrait de la partie de retenue (81).

7. Ensemble d'armoire de commande selon l'une quelconque des revendications 2 à 6, **caractérisé en ce que** les premières parties de charnière (16.1) dans la zone de leurs parties de retenue (81), en face des parties horizontales, orientées vers celles-ci, de la nervure en forme de cadre, sont munies d'évidements (89) dans la direction verticale, de manière à ne pas perturber l'étanchéité le long de la nervure en forme de cadre.

8. Ensemble d'armoire de commande selon l'une quelconque des revendications 1 à 7, **caractérisé en ce qu'**une porte partielle (16) est munie de deux parties de charnière (80), dont l'une est disposée en haut et l'autre en bas, les tenons (84) de chacune des parties de charnière s'avançant dans le sens opposé hors de la partie d'articulation (82) associée.
